# EUROPÄISCHE PATENTSCHRIFT

(11) **EP 2 048 679 B1**
(45) Veröffentlichungstag und Bekanntmachung des Hinweises auf die Patenterteilung: **07.04.2010**
(21) Anmeldenummer: 07019985.6
(22) Anmeldetag: 12.10.2007
(51) Int. Cl.: H01H 9/54, H01H 33/59, H02H 7/122

(54) **Lasttrenner-Anordnung**
Circuit breaker assembly
Agencement de sectionneur à coupure en charge

(43) Veröffentlichungstag der Anmeldung: 15.04.2009
(73) Patentinhaber: SMA Solar Technology AG, 34266 Niestetal (DE)
(72) Erfinder: Bremicker, Sven, 36211 Alheim-Baumbach (DE); Buchhold, Stefan, 34253 Lohfelden (DE); Greizer, Frank, 34260 Kaufungen (DE); Cramer, Günther, 34128 Kassel (DE)
(74) Vertreter: Walther, Walther & Hinz GbR

(56) Entgegenhaltungen:
- WO-A-2007/073951
- GB-A- 2 049 326
- JP-A- 2005 019 107
- US-A- 5 633 540
- US-A1- 2002 171 983
- US-B1- 6 741 435

## Beschreibung

Die Erfindung betrifft eine Lasttrenner-Anordnung zum An- und Abschalten eines DC-Stromes eines DC-Stromkreises in einer Photovoltaikanlage mit einem Halbleiter-Schaltelement zur Vermeidung eines Schaltlichtbogens, wobei eine elektronische Steuereinheit vorhanden ist, die derart ausgeführt ist, dass ein oder mehrere Signale von der Steuereinheit empfangen werden, und wobei die Lasttrenner-Anordnung so ausgeführt ist, dass in mindestens einer stromführenden Leitung des DC-Stromkreises im abgeschalteten Zustand eine galvanische Trennung durch einen automatisch durch die Steuereinheit steuerbaren Schaltkontakt besteht sowie ein oder mehrere Steuersignale an die Lasttrenner-Anordnung weitergegeben werden und wobei ein Halbleiter-Schaltelement den DC-Strom unterbricht, so dass der Schaltkontakt stromlos geschaltet wird.

Lasttrenner-Anordnungen zum Zu- und Abschalten eines DC-Stromes eines DC-Stromkreises in einer Photovoltaikanlage benötigen ein geeignetes Schaltmittel. Der von Sonnenenergie in Photovoltaikmodulen bzw. der in dem Solargenerator erzeugte DC-Strom, der beispielsweise von einem Wechselrichter in eine für ein Energieversorgungsnetz taugliche Wechselspannung umgewandelt wird, kann durch die Lasttrenner-Anordnung an den Wechselrichter weitergeleitet oder unterbrochen werden.

Es sind DC-Relais bekannt, die durch Schaltkontakte einen Strom unterbrechen können. Das Relais umfasst eine Steuerspule, die von einem elektrischen Strom durchflossen wird, so dass ein Metallanker anzieht. Dieser Metallanker ist mechanisch mit einem oder mehreren elektrischen Hauptkontakten verbunden. Die Hauptkontakte werden durch eine Anziehbewegung des Ankers in Richtung der Steuerspule ein- oder ausgeschaltet, je nachdem ob das Relais als Öffner oder Schließer ausgeführt ist. Ein solches Relais ist im Prinzip ein elektrisch steuerbarer Schalter.

Relais haben allerdings den Nachteil, dass Schaltlichtbögen, insbesondere beim Abschalten des DC-Stromes, entstehen. Dies führt kurzzeitig zu hohen Temperaturen und zu einem hohen Kontaktabbrand der Schaltkontakte. Dadurch können die Schaltkontakte leicht verschweißen, so dass sie praktisch verkleben und keine Stromunterbrechung mehr möglich ist. Dieses Phänomen ist unter dem Begriff "Kontaktschweißen" bekannt. Relais werden häufig für kleinere Ströme eingesetzt, die in der Regel 30 A nicht überschreiten.

Vergleichbare elektrisch steuerbare Schalter werden als Schütze bezeichnet. Sie sind im Vergleich zu Relais robuster ausgeführt und für höhere Ströme, zum Beispiel für bis zu mehreren 100 A, ausgelegt, wobei die Gefahr eines Kontaktverschweißens reduziert ist. Diese Gefahr lässt sich jedoch nicht gänzlich vermeiden. Die Schütze haben jedoch den Nachteil, dass sie relativ groß und auch teuer sind. Außerdem benötigen sie eine hohe Halteleistung für die Steuerspule. Nicht nur bei Photovoltaikanlagen ist man jedoch bestrebt, die erzeugte Energie so effektiv wie nur möglich einzusetzen.

Relais und Schütze haben aber den Vorteil, dass sie optional mit anreihbaren Hilfsschaltern ausgestattet werden können, die zu Kontrollzwecken oder anderen Steuerungszwecken eingesetzt werden können. So kann zum Beispiel ein Hilfskreis geschaffen werden, der durch den Hilfsschalter eine Signallampe ansteuert, die einen Fehler, wie z. B. einen Kurzschluss, signalisiert.

Als weitere Schaltgeräte sind Lastschalter oder Sicherungsautomaten bekannt. Solche Geräte sind Sicherungen bzw. automatisch auslösende Schalter, die bei einem hohen Strom abschalten. Diese Geräte weisen häufig eine Überstrom- und eine Kurzschiussschutzfunktion auf. Die Überstromschutzfunktion wird meistens durch einen um eine Bimetallfeder gewickelten Draht realisiert, der die Feder bei hohem Strom verbiegt, so dass ein mit Schaltkontakten verbundener Auslösemechanismus betätigt wird. Diese Überstromschutzfunktion ist träge. Bei einem Kurzschluss bzw. sehr hohem Strom wirken dagegen sehr schnell elektromagnetische Kräfte auf den Auslösemechanismus und/oder den Schaltkontakten selbst, so dass ein schnelles Auftrennen der Schaltkontakte möglich ist. Um entstehende Schaltlichtbögen zu reduzieren, werden, wie auch teilweise bei Schützen, Löschbleche eingesetzt. So ist die Gefahr eines Kontaktverschweißens eher gering. Eine Steuerung der Schaltkontakte ist jedoch nur mit speziellen Fernsteuerungsmodulen möglich, die sehr teuer sind und nur für Geräte hoher Ströme bzw. Schaltleistungen angeboten werden. Soll eine Abschaltung aufgrund eines anderen Ereignisses, wie ein Öffnen eines Gehäusedeckels erfolgen, sind Lösungen mit solchen Geräten nur für hohe Ströme und nur mit sehr hohen Kosten und einem erheblichen Platzverbrauch realisierbar.

Bei Photovoltaikanlagen kommt noch hinzu, dass dort Kurzschlussströme aufgrund der solarzellentypischen Kennlinie in der Regel 20 bis 40 % höher als im Nennbetrieb sind. Bei derartigen Sicherungen ist aber ein 50% bis 100% höherer Strom erforderlich, damit die Kurzschlusssicherung anspricht. So wird im Kurzschlussfall ein DC-Strom nicht oder nur sehr spät abgeschaltet.Dies ist jedoch aus Sicherheitsgründen nicht akzeptabel.

außerdem ist der Abschaltstrom immer größer als der Nennstrom, wobei,je größer der Überstrom ist, desto schneller schaltet die Sicherung ab. Bei nur kleinen Strömen kann es zur Überhitzung der Sicherung kommen. Daher ist der Einsatz einer solchen Sicherung zum Schutz in Photovoltaikanlagen nur bedingt geeignet.

Auch bekannt sind einfache Schmetzsicherungen. Eine solche Sicherung besteht aus einem in einem Gehäuse gekapselten Sicherungsdraht oder Streifenleiter, der an den Enden der Sicherung mit Kontaktelementen geführt und elektrisch verbunden ist. Das Gehäuse kann mit Luft, einem Gas oder anderen Füllmaterialien gefüllt sein. Fließt durch die Schmelzsicherung ein höherer Strom als der Nennstrom der Sicherung beträgt, dann schmilzt der Draht oder eingesetzte Leiter, so dass der Stromkreis unterbrochen wird.

Solche Schmelzsicherungen sind kostengünstig und zum Schutz von Geräten und elektrischen Komponenten, wie Schaltungen oder Leitungen, sehr geeignet und sogar für sehr große Ströme, wie mehrere 100A, und Spannungen, wie mehrere 100V, verfügbar. Eine Schmelzsicherung ist aber nach dem Auslösen nicht wieder zu verwenden und muss ausgetauscht werden. Als auslösendes Ereignis kann nur ein Überstrom betrachtet werden. Eine Stromunterbrechung aufgrund eines anderen Ereignisses ist nicht möglich.

Auch bekannt sind mechanische DC-Schalter. Diese weisen ein von Hand betätigbares Bedienelement auf. Von außen ist dieses Bedienelement zugänglich, so dass es durch eine Bewegung, wie Drehbewegung, Ziehbewegung oder Schiebebewegung, in eine oder mehrere andere Positionen gebracht werden kann. Durch die manuelle Bewegung wird ein Kontaktmechanismus betätigt, der wiederum einen elektrischen Hauptkontakt betätigt. Ein solcher Schalter ist ein manuell betätigbarer Schalter mit mehreren Kontaktpositionen, die durch verschiedene Raststellungen des Bedienteiles erreicht werden können. Sie können mehrere Kontakte gleichzeitig schalten, um zum Beispiel mehrere Stromkreise gleichzeitig zu trennen. Auch sind sie für hohe Schaltströme und Spannungen, wie mehrere 100A und mehrere 100V, geeignet. Sie haben jedoch den Nachteil, dass sie einen großen Platzbedarf und Verdrahtungsaufwand erfordern. Außerdem sind sie nur manuell bedienbar und daher nicht für Schutzfunktionen, wie Überstrom, und nicht zum automatischen Auslösen bei anderen Ereignissen brauchbar.

Andere Stromunterbrechungseinrichtungen, die für Photovoltaikänlagen geeignet sind, sind unter dem Begriff "Electronic Solar Switch (ESS)" bekannt und in der DE 102 25 259 B3 oder der DE 10 2004 054 933 B3 näher erläutert.

Der ESS ist in einer der beiden DC-Leitungen angeordnet. Wird ein mechanischer Schalter betätigt, dann schaltet ein parallel geschalteter Halbleiterschalter zu oder ab. Dadurch wird die Entstehung eines Lichtbogens verhindert bzw. reduziert. Der ESS ist also im Grunde ein manuell betätigbarer Schalter mit elektronischer Unterstützung zur Lichtbogenlöschung. Dieser ist an einem Photovoltaikwechselrichter angepasst und für einen Strom bis zu mehreren 10A und einer Spannung bis zu mehreren 100V geeignet. Ein solcher ESS ist nur manuell bedienbar.

Die DE 102 25 259 B3 beschreibt einen Steckverbinder, der einen Photovoltaikgenerator mit einem Wechselrichter verbindet. Durch manuelles Ziehen des Steckverbinders entsteht eine galvanische Trennung.

In der DE 10 2004 054 933 B3 wird eine Schutzabdeckung mit elektrischen Kontakten und mit einem Handgriff erläutert. Durch Entfernen der Schutzabdeckung von einem Wechselrichter und anschließendem Abziehen der DC-Stecker wird ein Photovoltaikgenerator vom Wechselrichter galvanisch getrennt.

Aus der WO 2007/073951 A ist eine Lasttrenner-Anordnung zum Zu- und Abschalten eines DC-Stromes eines DC-Stromkreises in einer Photovoltaikanlage mit einem Halbleiter-Schaltelement zur Vermeidung eines Schaltlichtbogens bekannt. Hierfür ist eine elektronische Steuereinheit vorhanden. In den stromführenden Leitungen des DC-Stromkreises erfolgt durch ein Relais im abgeschalteten Zustand eine galvanische Trennung, und zwar durch zwei automatisch durch die Steuereinheit steuerbaren Schaltkontakte. Weiterhin unterbricht das Halbleiter-Schaltelement den DC-Strom, so dass die Schaltkontakte stromlos geschaltet werden. Diese Schrift beschreibt einen Schalter mit einem Hauptschaltkontakt und einem Hilfskontakt, der mit der Steuerung verbunden ist. Gemäß dieser Lösung ist ein erster Strompfad mit dem Hauptkontakt und ein zweiter Strompfad mit einer Reihenschaltung aus einem Halbleiterschalter 2 und dem an einer Minuspolseite liegenden Relaiskontakt vorhanden. Der zweite mechanisch an das Relais gekoppelte zweiter Kontakt liegt an einer Pluspolseite.

Eine andere Lösung mit zwei Relais ist in der US 5,633,540 A beschrieben. Hier sind zwei Relais und ein Halbleiterschalter vorhanden. Ein Schaltkontakt des ersten Relais liegt in Reihe mit dem Schaltelement. Der Schaltkontakt des anderen Relais liegt parallel zu der Reihenschaltung.

Der Erfindung liegt die Aufgabe zugrunde, eine kostengünstige Lösung zu finden, mit der einerseits ein DC-Strom in einer Photovoltaikanlage sicher abzuschalten ist, und zwar nicht nur manuell sondern auch automatisch im Falle eines Fehlers, und andererseits eine galvanische Trennung in mindestens einer der zwei stromführenden Leitungen des DC-Stromkreises erzielt wird.

Diese Aufgabe wird erfindungsgemäß dadurch gelöst, dass die Signale Fehlersignale sind, die bei einem Fehler im PV-Generator, Wechselrichter oder der AC-Seite empfangen werden, wobei ein Zu- oder Abschalten des DC-Stromkreises durch die Steuersignale automatisch bei mindestens einem Fehlerfall erfolgt, wobei die Anordnung derart ausgeführt ist, dass beim Abschalten in einem ersten Schritt das Halbleiter-Schaltelement zunächst geschlossen wird, in einem zweiten Schritt Schaltkontakte eines ersten Schaltmittels geöffnet werden, so dass der DC-Strom durch das Halbleiter-Schaltelement fließt, in einem dritten Schritt das Halbleiter-Schaltelement wieder geöffnet wird, und in einem vierten Schritt Schaltkontakte eines zweiten Schaltmittels geöffnet werden, um die galvanische Trennung herbeizuführen, und dass ein zusätzlicher handbetätigbarer Lasttrenner angeschlossen ist, wobei der handbetätigbare Lasttrenner eine manuell trennbare, mit einer elektronischen Lichtbogenlöscheinrichtung versehene DC-Strom-Verbindungseinrichtung mit Steckkontakten für Photovoltaikanlagen ist. Die Erfindung beruht auf dem Gedanken wenigstens einen, insbesondere mindestens zwei elektrisch steuerbare Schalter mit Schaltkontakten einzusetzen.
Durch die Erfindung können zum einen Relais eingesetzt werden, die durch die Steuersignale der erfindungsgemäßen Steuerungseinheit automatisch gesteuert werden, ohne dass die Gefahr eines Kontaktverschweißens entsteht. Der Strom wird erfindungsgemäß durch das Halbleiter-Schaltelement getrennt, so dass kein Schaltlichtbogen im Relais entstehen kann. Zudem wird ein für die galvanische Trennung eingesetztes Relais, insbesondere nur stromlos geschaltet. Dies hat den Vorteil, dass ein erheblich höherer Strom im Nennbetrieb durch das Relais fließen kann. Das Relais muss daher nicht überdimensioniert werden. Die Relais sind außerdem klein, kostengünstig und benötigen im Vergleich zu Schützen eine geringe Halteleistung. Grundsätzlich kann aber auch ein Schütz eingesetzt werden. Das Halbleiterschaltelement kann auch periodisch aus- und eingeschaltet werden, so dass beim Abschalten ein geringerer Strom im Schaltkontakt fließt und so kein Schaltlichtbogen entsteht. Durch das Takten kann insbesondere im Gleichspannungsnetz das Entstehen eines stabilen Lichtbogens verhindert werden.

Auch kann die Lasttrenner-Anordnung in einfacher Weise zum Zuschalten oder Abschalten bei anderen Ereignissen als Kurzschlussfehler eingesetzt werden, weil eine einfache Ansteuerung der Relais möglich ist.
Die Erfindung verbindet die Vorteile von ESS-Lösungen und eines automatisierten Abschaltens. So entsteht während des Schaltvorgangs kein bzw. lediglich ein reduzierter, ungefährlicher Lichtbogen und damit keine Gefährdung von Personen oder der Anlage, wobei im Fehlerfall an die Steuereinheit der Lasttrenner-Anordnung ein Signal übertragen werden kann.

Die Erfindung beruht weiterhin auf dem Gedanken, ein ESS-Bedienkonzept (DE 102 25 259 B3 oder der DE 10 2004 054 933 B3) so zu verändern, dass der Laststrom nicht mehr durch einen mechanischen Steckverbinder getrennt wird und die Elektronik als Lichtbogenlöscher wirkt, sondern z.B. bei einem Betätigen eines Griffes nur ein Signal an die Steuereinheit gegeben wird, woraufhin diese den Abschaltvorgang steuert. Das Betätigen eines Griffes kann ein Ereignis im Sinne der Erfindung sein. Aber auch Fehler, wie z. B. ein Kurzschluss, können als Ereignis gesehen werden.

Zur Ausführung der Erfindung sind mindestens ein Relais, insbesondere zwei Relais oder mehr, zweckmäßig.

Durch das Verwenden von zwei Relais kann selbst bei Verschweißen einer der Kontakte eine galvanische Trennung aufrechterhalten werden.

Die Steuereinheit kann zudem speziell auf Photovoltaikanlagen angepasste Auslösebedingungen bei Über- oder Kurzschlussströme ausführen. In der Steuereinheit kann beispielsweise ein Mikroprozessor eingesetzt werden. Vorzugsweise ist die Steuereinheit in der Lasttrenner-Anordnung integriert.

Erfindungsgemäß ist ein zusätzlicher handbetätigbarer Lasttrenner, bzw. ein ESS-Lasttrenner, angeschlossen. Durch das Entfernen eines Steckverbinders oder eines Schutzdeckels mit Lichtbogenschutzfunktion kann, unabhängig von Steuersignalen der Steuereinheit, der DC-Stromkreis manuell aufgetrennt werden.

Eine bevorzugte Ausführungsform der Erfindung zeichnet sich dadurch aus, dass in der stromführenden Leitung des DC-Stromkreises zwei nacheinander durch Steuersignale schaltbare Schaltmittel mit Schaltkontakten, insbesondere zwei Relais, derart angeordnet sind, dass zum einen eines der Schaltmittel von dem Halbleiter-Schaltelement überbrückt wird, so dass durch ein Öffnen des Halbleiter-Schaltelementes der DC-Strom abgeschaltet wird, und zum anderen die galvanische Trennung des DC-Stromkreises durch das andere Schaltmittel entsteht. Dadurch wird in zuverlässiger Weise verhindert, dass eine galvanische Trennung durch Kontaktverschweißen verhindert wird. Während das erste Relais durch das Halbleiter-Schaltelement überbrückt wird, kann dieser nahezu stromlos öffnen, weil der Strom beim Öffnen des Kontakts in den geschalteten Halbleiterschalter wechselt. Dadurch bildet sich zunächst kein Lichtbogen aus. Da in dem Halbleiterschalter kein Lichtbogen entstehen kann, kann so der Strom gefahrlos auf null reduziert werden. Das zweite zur galvanische Trennung vorgesehene Relais kann dann stromlos geschaltet werden.

Um eine möglichst sichere Stromversorgung der Komponenten der Anordnung, d.h. Relais, Steuereinheit usw., zu gewährleisten, erfolgt mit Vorteil eine Spannungsversorgung der Lasttrenner-Anordnung sowohl von einer DC-Seite als auch von einer AC-Seite, so dass ebenfalls eine Redundanz vorliegt.

Weitere vorteilhafte Ausgestaltungen der Erfindung sind aus den Unteransprüchen zu entnehmen.

Anhand der Zeichnungen wird die Erfindung nachstehend beispielhaft näher erläutert. Es zeigen:
- Fig. 1: eine erste Schaltung einer Lasttrenner-Anordnung;
- Fig. 2: eine zweite Schaltung der erfindungsgemäßen Lasttrenner- Anordnung;
- Fig. 3: eine dritte Schaltung der erfindungsgemäßen Lasttrenner- Anordnung;
- Fig. 4: eine vierte Schaltung einer Lasttrenner-Anordnung.

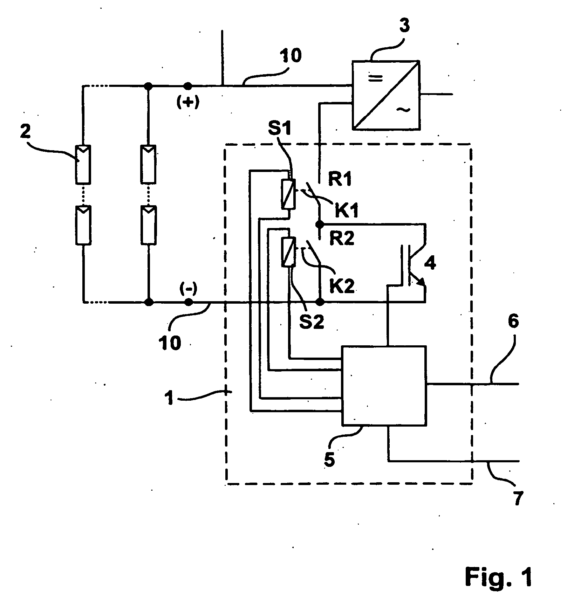

Fig. 1 veranschaulicht ein erstes Beispiel einer Lasttrenner-Anordnung 1. Diese umfasst zwei Relais R1 und R2. Jedes Relais weist eine Steuerspule S1, S2 mit einem Schaltkontakt K1, K2 bzw. Kontaktpaar auf. Beide Relais bzw., genauer gesagt, beide Schaltkontakte K1, K2 sind in Reihe geschaltet. Der Einfachheit halber wird jedoch von Relais gesprochen. Parallel zu dem Relais ist ein Halbleiter-Schaltelement 4, insbesondere ein IGBT-Schalter, geschaltet.

Die Anordnung 1 liegt in einem DC-Stromkreis mit DC-Leitungen 10 zwischen einem Photovoltaikgenerator 2, einer Photovoltaikanlage und einem Wechselrichter 3 bzw. einem DC/AC-Umrichter. Ist der Photovoltaikgenerator 2 dem Wechselrichter 3 zugeschaltet, dann sind beide Relais R1, R2 geschlossen. Beide Relais sind so ausgelegt, dass sie im geschlossenen Zustand den erforderlichen Laststrom führen können.

Weiterhin umfasst die Anordnung 1 eine elektronische Steuereinheit 5, die mit den Relais R1, R2 bzw. dessen Steuerspulen S1, S2 verbunden ist und so durch Steuersignale die Schaltkontakte K1, K2 automatisch betätigen kann. Zudem ist das Halbleiter-Schaltelement ebenfalls durch die Einheit 5 steuerbar.

Soll die Verbindung zwischen dem Photovoltaikgenerator 2 und dem Wechselrichter 3 getrennt werden, wird zunächst das Halbleiter-Schaltelement 4 geschlossen. In einem zweiten Schritt wird das Relais R2 geöffnet, so dass der Laststrom durch die Reihenschaltung aus Relais R1 und dem Halbleiter-Schaltelement 4 fließt. In einem dritten Schritt wird das Schaltelement 4 geöffnet, so dass der volle Laststrom abgeschaltet werden kann, ohne dass ein Lichtbogen auftritt. Dadurch wird ein Lichtbogen verhindert. In einem vierten Schritt wird das Relais R1 geöffnet. Dadurch wird eine galvanische Trennung zwischen Generator 2 und Wechselrichter 3 realisiert. Da das Relais R1 stromlos öffnet, kann sich an seinem Kontakt K1 kein Lichtbogen ausbilden. Ein Zuschalten des DC-Stromes erfolgt in umgekehrter Reihenfolge.

Diese Schritte werden von der Steuereinheit 5 gesteuert, d.h. dass die Ansteuerung der Relais R1, R2 und des Schaltelements 4 über eine Steuerelektronik der Steuereinheit 5 erfolgt. Über eine Steuerleitung 6 kann ein Ereignissignal zum Zu- oder Abschalten gegeben werden. Auslösende Ereignisse können ein Überstrom, eine Überspannung, eine zu hohe Temperatur, ein Feuer in einem Gerät, ein Defekt eines Gerätes, ein manueller Abschaltbefehl, ein externer, elektrischer Befehl, eine Öffnung eines Gerätedeckels, ein Ausfall eines öffentlichen Niederspannungsnetzes und/oder ein Diebstahl der Photovoltaikanlage sein. Solche Ereignisse können über eine gesonderte Elektronik bzw. Sensorik erfasst werden.

Eine Auswertung, ob ein Ereignis bzw. Fehlerfall vorliegt, kann entweder von der Steuereinheit 5 oder durch eine externe elektronische Einheit, insbesondere durch eine Einheit bzw. Elektronik im Wechselrichter 3, erfolgen. Bei beiden Varianten wird die Steuerleitung 6 genutzt. Alternativ können mehrere Steuerleitungen eingesetzt werden, um verschiedene Ereignis-Signale parallel übertragen zu können. Auch eine Ausführung der Leitung 6 als digitale Kommunikationsleitung oder Bus, beispielsweise RS232 oder CAN, ist möglich. Ebenfalls kann die Anordnung 1 über die Leitung 6 oder eine andere Steuer- und Kommunikationsleitung eine Meldung an eine weitere, externe elektronische Einheit weitergeben, um z.B. zu signalisieren, dass eine selbsttätige Abschaltung infolge eines Ereignisses erfolgt ist. Hierbei kann auch eine erkannte Fehlerursache über diese Leitung übertragen werden.

Weiterhin ist die Steuereinheit 5 mit einer Spannungsversorgungsleitung 7 versehen, die vorzugsweise redundant angeschlossen ist, indem ein Versorgungsanschluss sowohl auf der DC-Seite bzw. Photovoltaikseite als auch auf der AC-Seite bzw. Netzseite erfolgt._{.}

Das Relais R1 oder vorzugsweise beide Relais R1, R2 sind so ausgelegt, dass sie im geöffneten Zustand jeweils eine maximale Leerlaufspannung des DC-Stromkreises halten. Da die Relais R1, R2 nicht den Strom abschalten, können Relais mit geringerer Halteleistung eingesetzt werden. Ein direktes Abschalten des Laststromes würde nämlich wesentlich größere und robustere Relais mit hoher Halteleistung erfordern.

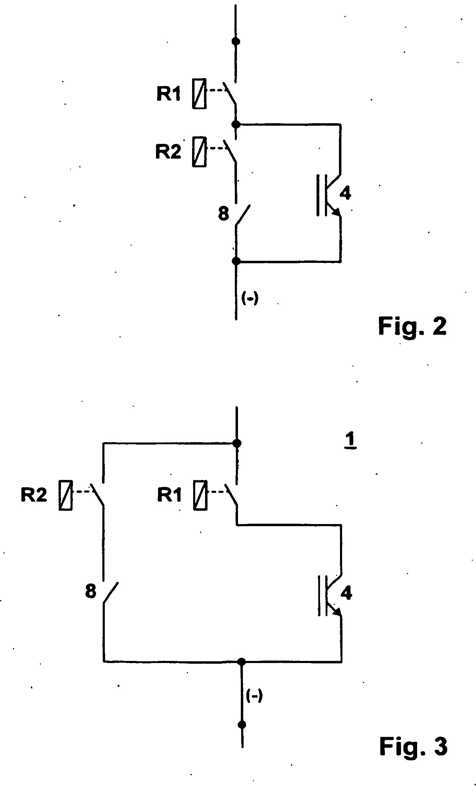

Eine erfindungsgemäße Schaltung ist in Fig. 2 gezeigt, wobei diese nur die Schalteranordnung zeigt. Diese Variante zeichnet sich dadurch aus, dass ein zusätzlicher handbetätigbarer Lasttrenner 8, insbesondere ein ESS-Lasttrenner, angeschlossen ist, und zwar in Reihe zu Relais R2. Der Lasttrenner 8 kann aber auch ein anderer Schalter, mechanischer Kontakt oder Steckverbinder sein. Durch diese Variante kann sowohl ein vollständig automatisierter Abschaltvorgang ausgelöst werden als auch ein vollmanueller Abschaltvorgang durchgeführt werden. Beim manuellen Vorgang kann eine Spannungsversorgung des ESS aus der im DC-Kreis gespeicherten Energie erfolgen, die bei einem Lichtbogen entstehen würde. Zusätzlich oder alternativ kann eine Spannungsversorgung des ESS aus der beim Trennen des Relais R2 entstehenden Energie, die ein Lichtbogen verursachen würde, erfolgen. Hierdurch bleibt eine sichere Trennbarkeit auch im Falle eines Versagens mehrerer Komponenten unter Vermeidung eines Lichtbogens erhalten.

Denkbar ist auch, auf das.Relais R1 nach Fig. 2 zu verzichten. Dadurch wird ein ESS-Konzept so erweitert, dass auch Forderungen nach einer größeren Anzahl an Schaltspielen erfüllt werden können, ohne ein mechanisches Bedienkonzept zu verändern.

Als ESS ist eine manuell trennbare, mit einer elektronischen Lichtbogenlöscheinrichtung versehene DC-Strom-Verbindungseinrichtung mit Steckkontakten für Photovoltaikanlagen zu verstehen.

Eine andere Variante der erfindungsgemäßen Schattungs-Anordnung zeigt Fig. 3, in der ebenfalls nur die Schalter dargestellt sind. Sie unterscheidet sich von der in Fig. 2 dadurch, dass sich in Reihe zu Relais R2 der Lasttrenner 8 befindet und dass das Halbleiter-Schaltelement 4 in Reihe zum Relais R1 angeordnet ist Beide Relais R1 und R2 sind parallel geschaltet.

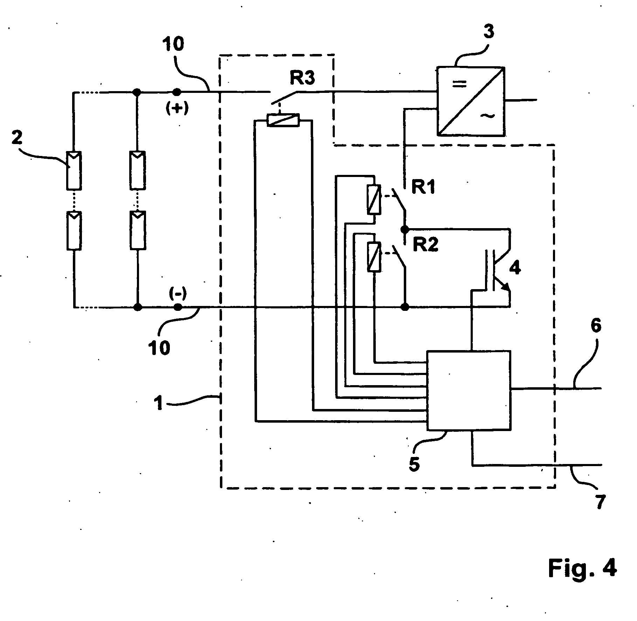

Eine weitere Variante wird in Fig. 4 veranschaulicht. Sie ist vergleichbar mit der in Fig. 1. Allerdings ist zusätzlich in der DC(+)-Leitung ein drittes Relais R3 geschaltet, damit beide Leitungen 10 bzw. DC(+) und DC(-) jeweils durch mindestens ein Relais getrennt werden. Dadurch wird an beiden Polen eine galvanische Trennung erzielt. Das Relais R3 ist vorzugsweise so ausgelegt, dass es ebenfalls den vollen Laststrom führen kann. Da durch die Schattung ein Abschalten des vollen Laststromes durch das dritte Relais R3 nicht vorgesehen ist, kann dieses ebenfalls ein kleines Relais mit nur geringer Halteleistung sein.

### BEZUGSZEICHENLISTE

- 1: Lasttrenner-Anordnung
- 2: Photovoltaikgenerator
- 3: Wechselrichter
- 4: Halbleiterschaltelement
- 5: Elektronische Steuereinheit
- 6: Steuerleitung
- 7: Spannungsversorgungsleitung
- 8: handbetätigbarer Lasttrenner
- 9: -
- 10: DC-Leitungen

- R1,R2,R3: Relais
- S1, S2: Steuerspulen
- K1, K2: Schaltkontakte

## Patentansprüche

1. Lasttrenner-Anordnung (1) zum Zu- und Abschalten eines DC-Stromes eines DC-Stromkreises in einer Photovoltaikanlage mit einem Halbleiter-Schaltelement (4) zur Vermeidung eines Schaltlichtbogens, wobei eine elektronische Steuereinheit (5) vorhanden ist, die derart ausgeführt ist, dass ein oder mehrere Signale von der Steuereinheit empfangen werden, und wobei die Lasttrenner-Anordnung (1) so ausgeführt ist, dass in mindestens einer stromführenden Leitung des DC-Stromkreises im abgeschalteten Zustand eine galvanische Trennung durch einen automatisch durch die Steuereinheit (5) steuerbaren Schaltkontakt besteht sowie ein oder mehrere Steuersignale an die Lasttrenner-Anordnung (1) weitergegeben werden und wobei ein Halbleiter-Schaltelement (4) den DC-Strom unterbricht, so dass der Schaltkontakt stromlos geschaltet wird,
**dadurch gekennzeichnet,**
- **dass** die Signale Fehlersignale sind, die bei einem Fehler im PV-Generator, Wechselrichter oder der AC-Seite empfangen werden, wobei ein Zu- oder Abschalten des DC-Stromkreises durch die Steuersignale automatisch bei mindestens einem Fehlerfall erfolgt,
wobei die Anordnung derart ausgeführt ist, dass beim Abschalten
- in einem ersten Schritt das Halbleiter-Schaltelement (4) zunächst geschlossen wird,
- in einem zweiten Schritt Schaltkontakte (K1, K2) eines ersten Schaltmittels geöffnet werden, so dass der DC-Strom durch das Halbleiter-Schaltelement (4) fließt,
- in einem dritten Schritt das Halbleiter-Schaltelement (4) wieder geöffnet wird und
- in einem vierten Schritt Schaltkontakte (K1, K2) eines zweiten Schaltmittels geöffnet werden, um die galvanische Trennung herbeizuführen,
- und **dass** ein zusätzlicher handbetätigbarer Lasttrenner (8) angeschlossen ist, wobei der handbetätigbare Lasttrenner (8) eine manuell trennbare, mit einer elektronischen Lichtbogenlöscheinrichtung versehene DC-Strom-Verbindungseinrichtung mit Steckkontakten für Photovoltaikanlagen ist.

2. Lasttrenner-Anordnung nach Anspruch 1,
**dadurch gekennzeichnet,**
**dass** in der stromführenden Leitung des DC-Stromkreises zwei nacheinander durch Steuersignale schaltbare Schaltmittel mit Schaltkontakten (K1,K2), insbesondere zwei Relais (R1, R2), derart angeordnet sind, dass zum einen eines der Schaltmittel von dem Halbleiter-Schaltelement (4) überbrückt wird, so dass durch ein Öffnen des Halbleiter-Schaltelementes (4) der DC-Strom abgeschaltet wird, und zum anderen die galvanische Trennung des DC-Stromkreises durch das andere Schaltmittel entsteht.

3. Lasttrenner-Anordnung nach Anspruch 2,
**dadurch gekennzeichnet,**
**dass** eines der Schaltmittel in Reihe mit dem Halbleiter-Schaltelement (4) angeordnet ist.

4. Lasttrenner-Anordnung nach einem der Ansprüche 2 oder 3,
**dadurch gekennzeichnet,**
**dass** die Schaltkontakte der Schaltmittel in Reihe geschaltet sind.

5. Lasttrenner-Anordnung nach einem der Ansprüche 2 bis 4,
**dadurch gekennzeichnet,**
**dass** ein drittes Schaltmittel mit Schaltkontakten (K1, K2) in einer anderen stromführenden Leitung des DC-Stromkreises angeschlossen ist.

6. Lasttrenner-Anordnung nach einem der vorhergehenden Ansprüche,
**gekennzeichnet durch**
mindestens zwei Relais (R1,R2, R3).

7. Lasttrenner-Anordnung nach einem der vorhergehenden Ansprüche,
**dadurch gekennzeichnet,**
**dass** ein Zu- oder Abschalten erfolgt bei:
- einem Überstrom,
- einer Überspannung,
- einer zu hohen Temperatur,
- einem Feuer in einem Gerät,
- einem Defekt eines Gerätes,
- einem manuellen Abschaltbefehl,
- einem externen, elektrischen Befehl,
- einer Öffnung eines Gerätedeckels,
- einem Ausfall eines öffentlichen Niederspannungsnetzes und/oder
- einem Diebstahl der Photovoltaikanlage.

8. Lasttrenner-Anordnung nach einem der vorhergehenden Ansprüche,
**dadurch gekennzeichnet,**
**dass** eine externe Steuerleitung (6) der Steuereinheit (5) vorhanden ist und die Steuereinheit (5) außerhalb der Lasttrenner-Anordnung (1) angeordnet ist, insbesondere in einem Solarwechselrichter angeordnet ist, oder dass die Steuereinheit (5), insbesondere eine Fehlererkennungseinheit, in eine Steuerelektronik der Lasttrenner-Anordnung (1) integriert ist.

9. Lasttrenner-Anordnung nach einem der vorhergehenden Ansprüche,
**dadurch gekennzeichnet,**
**dass** eine Spannungsversorgung der Lasttrenner-Anordnung sowohl von einer DC-Seite als auch von einer AC-Seite erfolgt.

## Claims

1. A load breaker arrangement (1) for switching on and
off a DC current of a DC current circuit in a photovoltaic plant with a semiconductor switching element (4) to avoid a switching arc, there being provided an electronic control unit (5) configured such that one or more signals are received by the control unit, and the load breaker arrangement (1) being configured such that in at least one current-carrying line of the DC current circuit there is galvanic separation by a switching contact that is automatically controllable by the control unit (5) in the switched-off condition and one or more control signals being transmitted to the load breaker arrangement (1) and a semiconductor switching element (4) interrupting the DC current so that the switching contact is de-energized,
**characterized in**
- **that** the signals are flaw signals that are received in case of a flaw in the PV generator, inverter or on the AC side, the DC current circuit being automatically switched on or off by the control signals in case of at least one flaw,
said arrangement being configured such that, during switch off,
- said semiconductor switching element (4) is at first closed in a first step,
- the switching contacts (K1, K2) of a first switching means are opened in
a second step for the DC current to flow through said semiconductor switching element (4),
- said semiconductor switching element (4) being again opened in a third step and
- switching contacts (K1, K2) of a second switching means being opened in order to cause galvanic separation to occur
- and **that** an additional manually operable load breaker (8) is connected, said manually operable load breaker (8) being a manually breakable DC current connecting system with plug contacts for photovoltaic plants that is provided with an electronic arc quenching system.

2. The load breaker arrangement as set forth in claim 1,
**characterized in that**, in the current-carrying line of the DC current circuit, there are arranged two switching means that are switchable one after the other through control signals, said switching means having switching contacts (K1, K2), in particular two relays (R1, R2), in such a manner that on the one side one of the switching means is bridged by the semiconductor switching element (4) for the DC current to be switched off by opening the semiconductor switching element (4), and that on the other side galvanic separation of the DC current circuit occurs through the other switching means.

3. The load breaker arrangement as set forth in claim 2,
**characterized in that** one of the switching means is mounted in series with the semiconductor switching element (4).

4. The load breaker arrangement as set forth in any one of the claims 2 or 3,
**characterized in that** the switching contacts of the switching means are connected in series.

5. The load breaker arrangement as set forth in any one of the claims 2 through 4,
**characterized in that** a third switching means with switching contacts (K1, K2) is connected in another current-carrying line of the DC current circuit.

6. The load breaker arrangement as set forth in claim 1,
**characterized by** at least two relays (R1, R2, R3).

7. The load breaker arrangement as set forth in claim 1,
**characterized in that** switching on or off occurs in the event of:
- an overcurrent,
- an overvoltage,
- too high a temperature,
- fire in an apparatus,
- a flaw in an apparatus,
- a manuel switch-off command,
- an external electrical command,
- opening of a cover of the apparatus,
- failure of a public low-voltage utility grid and/or
- theft of the photovoltaic plant.

8. The load breaker arrangement as set forth in claim 1,
**characterized in that** an external control line (6) of the control unit (5) is provided and that the control unit (5) is arranged outside of the load breaker arrangement (1), in particular in a solar inverter, or that said control unit (5), in particular a flaw detection unit, is integrated in a control electronics of the load breaker arrangement (1).

9. The load breaker arrangement as set forth in claim 1,
**characterized in that** a voltage supply of the load breaker arrangement occurs both from a DC side and from an AC side.

## Revendications

1. Dispositif de coupure en charge (1) destiné à déconnecter et connecter un courant continu d'un circuit à courant continu dans une installation photovoltaïque, comprenant un élément de commutation à semi-conducteur (4) prévu pour éviter un arc de commutation, dans lequel il est prévu une unité de commande électronique (5) qui est constituée de manière qu'un ou plusieurs signaux soient reçus par l'unité de commande, et dans lequel le dispositif de coupure en charge (1) est constitué de manière que, dans au moins une ligne sous tension du circuit à courant continu, à l'état déconnecté, une coupure galvanique soit établie par le contact de commutation pouvant être commandé automatiquement par l'unité de commande (5) et qu'un ou plusieurs signaux de commande soient transmis au dispositif de coupure en charge (1), et dans lequel un élément de commutation à semi-conducteur (4) interrompt le courant continu, de sorte que le contact de commutation est hors tension,
**caractérisé en ce que**
- les signaux sont des signaux de défaut qui sont reçus en présence d'un défaut dans le générateur PV, dans l'onduleur ou dans le côté courant alternatif, une connexion ou une déconnexion du circuit à courant continu étant établie automatiquement par les signaux de commande en présence d'au moins un cas de défaut,
le dispositif étant constitué de telle manière que, lors de la déconnexion,
- dans une première étape, l'élément de commutation (4) est tout d'abord fermé,
- dans une deuxième étape, des contacts de commutation (K1, K2) d'un premier moyen de commutation sont ouverts, de sorte que le courant continu circule alors à travers l'élément de commutation à semi-conducteur (4),
- dans une troisième étape, l'élément de commutation à semi-conducteur (4) est de nouveau ouvert, et
- dans une quatrième étape, des contacts de commutation (K1, K2) d'un deuxième moyen de commutation sont ouverts pour provoquer la coupure galvanique,
- et **en ce qu'**un dispositif de coupure en charge (8) supplémentaire pouvant être commandé manuellement est raccordé, le dispositif de coupure (8) pouvant être commandé manuellement étant un dispositif de liaison à courant continu pouvant être coupé manuellement, muni de contacts embrochables pour installations photovoltaïques et équipé d'un dispositif d'extinction d'arc électronique.

2. Dispositif de coupure en charge selon la revendication 1,
**caractérisé en ce que**
deux moyens de commutation possédant des contacts de commutation (K1, K2) pouvant être commutés l'un après l'autre par des signaux de commande, en particulier deux relais (R1, R2), sont disposés dans la ligne sous tension du circuit à courant continu de telle manière que, d'une part, un des éléments de commutation est shunté par l'élément de commutation à semi-conducteur (4), de sorte que le courant continu est alors déconnecté par une ouverture de l'élément de commutation à semi-conducteur et que, d'autre part, la coupure galvanique du circuit à courant continu est établie par l'autre élément de commutation.

3. Dispositif de coupure en charge selon la revendication 2,
**caractérisé en ce que**
un des moyens de commutation est disposé en série avec l'élément de commutation à semi-conducteur (4).

4. Dispositif de coupure en charge selon l'une des revendications 2 ou 3,
**caractérisé en ce que**
les contacts de commutation des moyens de commutation sont connectés en série.

5. Dispositif de coupure en charge selon l'une des revendications 2 à 4,
**caractérisé en ce que**
un troisième élément de commutation équipé de contacts de commutation (K1, K2) est intercalé dans une autre ligne sous tension du circuit à courant continu.

6. Dispositif de coupure en charge selon l'une des revendications précédentes,
**caractérisé par**
au moins deux relais (R1, R2, R3).

7. Dispositif de coupure en charge selon l'une des revendications précédentes,
**caractérisé en ce que**
il s'établit une connexion ou une déconnexion en présence:
- d'une surintensité,
- d'une surtension,
- d'une trop haute température,
- d'un feu dans un appareil,
- d'un défaut d'un appareil,
- d'un ordre de déconnexion manuel,
- d'un ordre électrique externe,
- de l'ouverture du couvercle d'un appareil,
- d'une défaillance d'un réseau public à basse tension, et/ou
- d'un vol de l'installation photovoltaïque.

8. Dispositif de coupure en charge selon l'une des revendications précédentes,
**caractérisé en ce que**
il est prévu une ligne de commande externe (6) de l'unité de commande (5) et que l'unité de commande (5) est disposée à l'extérieur du dispositif de coupure en charge (1), en particulier dans un onduleur solaire, ou que l'unité de commande (5), en particulier une unité de reconnaissance de défauts, est intégrée dans une électronique de commande du dispositif de coupure en charge (1).

9. Dispositif de coupure en charge selon l'une des revendications précédentes,
**caractérisé en ce que**
l'alimentation en tension du dispositif de coupure en charge s'effectue aussi bien par le côté courant continu que par le côté courant alternatif.
